(19) Europäisches Patentamt
European Patent Office
Office européen des brevets

(11) EP 0 452 139 B1

(12) EUROPEAN PATENT SPECIFICATION

(45) Date of publication and mention
of the grant of the patent:
**25.02.1998 Bulletin 1998/09**

(51) Int Cl.[6]: **C08G 18/80**, C08G 18/12,
C08G 18/67, C08G 18/34,
C08G 18/66

(21) Application number: **91303234.8**

(22) Date of filing: **11.04.1991**

(54) **Process for the preparation of printing plates from urethane polymers**

Verfahren zur Herstellung von Druckplatten aus Urethanpolymeren

Procédé de prèparation de plaques d'impression à partir de polymères d'uréthane

(84) Designated Contracting States:
**DE FR GB**

(30) Priority: **12.04.1990 GB 9008339**
**23.04.1990 GB 9009057**

(43) Date of publication of application:
**16.10.1991 Bulletin 1991/42**

(73) Proprietor: **MacDermid Imaging Technology Inc.**
**Waterbury, CT 06702 (US)**

(72) Inventor: **Yokoyama, Wako**
**Wilmington, Delaware 19808 (US)**

(74) Representative:
**De Minvielle-Devaux, Ian Benedict Peter et al**
**CARPMAELS & RANSFORD**
**43, Bloomsbury Square**
**London WC1A 2RA (GB)**

(56) References cited:
**FR-A- 2 607 820** **US-A- 4 153 778**

• **CHEMICAL ABSTRACTS, vol. 106, no. 16, 20 April 1987, Columbus, Ohio, US; abstract no. 120403N,**

## Description

This invention relates to a process for the preparation of printing plates from photocurable polyurethane compositions.

The use of various photopolymer resin compositions to make printing plates is known. For example, U.S. Patent 4,358,354 describes a urethane photosensitive resinous composition comprising at least one urethane prepolymer having carboxyl groups and acrylic residues only at the terminals of the molecule, (b) an ethylenically unsaturated compound and (c) a photopolymerization initiator. The composition provides letterpress printing plates that are substantially free of surface tack and have good resistance to moisture and to abrasion and wear.

However, there is still a need in the art for improved photopolymer resin compositions that eliminate surface tack and improve plate washout and suspension of the washed out polymer in the bath.

JP-A-61-168610 discloses that urethane oligomers may be obtained by reacting a polyalcohol, e.g. polyethylene glycol, and 1-50% by weight, based on the total alcohol, of dimethylolpropionic acid, of the formula Me $(HOCH_2)_2CCO_2H$, with a polyisocyanate, e.g. tolylene diisocyanate, at an OH/NCO molar ratio of less than 1 to form an isocyanate-terminated oligomer. The latter is reacted with an OH-containing (meth)acrylate. The resultant urethane oligomer may be mixed with a reactive diluent, e.g. trimethylolpropane tri(meth)acrylate, and a photopolymerization initiator, e.g. methyl o-benzoylbenzoate, to form a photocurable resin composition useful for inks (or paints), adhesives and photoresist coatings.

JP-A-63-54416 discloses a UV-curable urethane (meth)acrylate resin composition suitable for silk-screen printing inks, which resin composition is prepared by reacting a mixture of 5-70 mol% of a diol having a molecular weight of at least 1500, e.g. polytetramethylene glycol, or higher and 30-95 mol% of a diol having a molecular weight of 200 or less, e.g. polypropylene glycol, together with an organic diisocyanate and also a (meth)acrylate of specified general formula, e.g. 2-hydroxyethyl acrylate.

The present invention provides a printing plate manufactured from a urethane polymer that has free carboxyl groups and terminal methacrylate groups and that is obtainable by a process that comprises (1) reacting a mixture of at least two aliphatic diols and an aliphatic dihydroxy mono- or dicarboxylic acid with an excess of an aliphatic, cycloaliphatic or aromatic diisocyanate in the presence of a catalyst to produce an isocyanate-terminated urethane polymer having free carboxyl groups on the polymer backbone, and (2) reacting the terminal isocyanate groups of the product of step (1) with an aliphatic monohydroxy methacrylate.

The mixture of diols used in step (1) of the above process includes at least two aliphatic diols, preferably those having a weight average molecular weight of 1000 to 4000. Suitable aliphatic diols include polyethylene glycol; polypropylene glycol; a block copolymer made by reacting a propylene oxide polymer with ethylene oxide; polytetrahydrofuran diol; polypropylene adipate diol; neopentyl glycol adipate diol; 1,4-butanediol ethylene glycol adipate diol; 1,6-hexanediol phthalate adipate neopentyl glycol phthalate adipate diol and ethylene glycol adipate diol. An aliphatic dihydroxy mono- or dicarboxylic acid is also used in step (1). Suitable dihydroxy carboxylic acids include bis-hydroxymethylpropionic acid, 2,3-dihydroxybutanoic acid; 2,4-dihydroxy-3,3-dimethylbutanoic acid; 2,3-dihydroxyhexadecanoic acid; dihydroxybutenoic acid, tartaric acid and 2,3-dihydroxy-2-methylpropionic acid. Bis-hydroxymethylpropionic acid is preferred. The concentration of hydroxy-functional carboxylic acid can be varied from 0.2% to 30%. From 2% to 5% is preferred. In this specification, all percentages are by weight, based on the total weight of the components used to prepare the urethane polymer.

The mixture of diols is reacted with an excess of an aliphatic, cycloaliphatic or aromatic diisocyanate. Suitable diisocyanates include, for example, 2,4- or 2,6-toluene diisocyanate; isophorone diisocyanate; 1,6-hexamethylene diisocyanate; 2,2,4-trimethylhexamethylene-1,6-diisocyanate; p,p'-methylene-bis-phenylisocyanate or mixtures thereof.

The equivalent hydroxyl to isocyanate ratio for the reaction can vary from 1:1.1 to 1:2.0. A ratio of 1:1.4 is preferred. The reaction temperature is preferably from 40°C to 90°C, most preferably from 70°C to 80°C. The reaction is preferably carried out in the presence of 50 to 300 ppm of an organic tin compound or from 0.1 to 3% of an aliphatic amine compound as a catalyst. Suitable catalysts include, for example, dioctyltin bis(isooctylmercaptoacetate), dibutyltin dilaurate, dibutyltin diisooctylmaleate, triethylenediamine, triethanolamine and triethylamine. Dioctyltin bis(isooctylmercaptoacetate) is preferred. The urethane polymer that is formed is characterized by the presence of free carboxylic acid groups on the backbone of the polymer and isocyanate groups at the ends of the polymer chain. The presence of the free carboxyl groups in the final product improves plate washout and suspension of the washed out urethane polymer in the alkaline washout bath.

In the second step of the reaction, the product from step (1) is reacted with an aliphatic monohydroxy methacrylate in an amount sufficient to react with the isocyanate groups at the ends of the polymer chain. From 0.2 to 10 equivalents of excess hydroxy-functional methacrylate are preferred. Suitable methacrylates include, for example, 2-hydroxypropyl methacrylate, butanediol monomethacrylate, polyethylene glycol (10-20 moles ethylene oxide) monomethacrylate and polypropylene glycol (5-20 moles propylene oxide) methacrylate. An organic tin compound or an aliphatic amine compound of the types and amounts specified above can be used as a catalyst for this reaction if desired. The resulting urethane polymer is a liquid, has methacrylate groups on the ends of the polymer chain, free carboxyl groups on the polymer backbone, and an acid number of 1 to 150.

The urethane polymers can then be blended with polymerizable monomers, photoinitiators and stabilizers to produce a composition that is sensitive to actinic radiation and can be used to produce low tack or tack-free flexographic printing plates. To produce the plates the liquid composition is exposed to ultraviolet radiation through a negative, the unexposed portion is washed away with an aqueous alkaline detergent solution, and the plate is exposed to ultraviolet radiation in air. Production of 150 to 250 plates per hour can be achieved in this manner.

Example 1

A urethane polymer is made from the following charge according to the process of this invention:

|  | Eq. Wt. | Wt. % | Equiv. |
|---|---|---|---|
| Poly G 55-53 | 995 | 29.28 | 0.0294 |
| Poly G 20-56 | 996 | 42.63 | 0.0428 |
| Bis-hydroxymethyl-propionic acid | 67 | 2.37 | 0.0353 |
| Toluene diisocyanate | 87.1 | 14.07 | 0.1615 |
| 2-Hydroxypropyl methacrylate | 144 | 3.88 | 0.0269 |
|  | — | 99.99 |  |

The Poly G 55-53, Poly G 20-56, and bis-hydroxymethylpropionic acid are dried under a nitrogen purge for 12 hours at approximately 60°C. ("Poly G" may be a registered trade mark.) Poly G 20-56 is polypropylene glycol and Poly G 55-53 is a block copolymer made by reacting ethylene oxide with a propylene oxide polymer. Both have a weight average molecular weight of about 2000 and are available from Olin Chemical Co. Dioctyltin bis(isooctylmercaptoacetate) catalyst (0.015%) is added, followed by the toluene diisocyanate. The reaction mixture, still under nitrogen, is heated to 75° to 80°C. Samples are taken for isocyanate analysis. At 1.8% isocyanate, the 2-hydroxypropyl methacrylate containing 0.10% (by weight of the total composition) butylated hydroxytoluene as a stabilizer and 0.015% (by weight of the total composition) of the same tin catalyst are added under an air atmosphere. The final product has an acid number of 10.2.

Example 2

A urethane polymer is prepared as follows. Poly G 55-53 (37.01 g), 53.88 g Poly G 20-56 and 2.00 g tartaric acid are dried under a nitrogen purge overnight at approximately 60°C. The mixture is cooled to approximately 45° to 50°C and 0.015 wt. % dioctyltin bis(isooctylmercaptoacetate) catalyst is added. Toluene diisocyanate (13.36 g) is added in 1/3 increments at 45° to 50°C. After 30 minutes the reaction mixture, still under nitrogen, is heated to 70°C. The OH/ NCO equivalent ratio is 1:1.3. Samples are taken for isocyanate analysis. At 1.5 to 2.0% isocyanate, 7.65 g 2-hydroxypropyl methacrylate containing 0.015 wt. % (based on the total weight of the composition) of the same tin catalyst and 0.10 wt. % (based on the total weight of the composition) butylated hydroxytoluene as a stabilizer are added under an air atmosphere. The temperature is then raised to approximately 75°C until the % NCO is less than 0.1 to 0.3%. The final product has an acid number of 18.

Example 3

A proprietary photopolymerizable resin formulation containing the urethane polymer prepared as described in Example 1 is processed through a MERIGRAPH® SR-Y plate maker (Hercules Incorporated) at 215 plates/hour. The plates have low tack and are processable through a semi-automatic trim and bender machine supplied by K&F Printing Systems International. About 35,000 impressions of a 64 page edition consisting of old newspaper headlines are printed successfully. No solids build-up or fill-in are observed.

It will of course be understood that the present invention has been described above purely by way of example and that modifications of detail can be made within the scope of the invention.

**Claims**

1. A printing plate manufactured from a urethane polymer, characterized in that the urethane polymer has free carboxyl groups and terminal methacrylate groups and is obtainable by a process that comprises (1) reacting a mixture of at least two aliphatic diols and an aliphatic dihydroxy mono- or dicarboxylic acid with an excess of an aliphatic, cyclo-aliphatic or aromatic diisocyanate in the presence of a catalyst to produce an isocyanate-terminated urethane polymer having free carboxyl groups on the polymer backbone and (2) reacting the terminal isocyanate groups of the product of step (1) with an aliphatic monohydroxy methacrylate.

2. The printing plate of claim 1, characterized in that the aliphatic diols are a mixture of polypropylene glycol and a block copolymer of polypropylene oxide and ethylene oxide.

3. The printing plate of claim 1 or 2, characterized in that the dihydroxy monocarboxylic acid is bis-hydroxymethyl-propionic acid.

4. The printing plate of claim 1, 2 or 3, characterized in that the diisocyanate is toluene diisocyanate.

5. The printing plate of any of the preceding claims, characterized in that the monohydroxy methacrylate is 2-hydroxypropyl methacrylate.

6. The printing plate of any of the preceding claims, characterized in that the catalyst is an organic tin compound.

7. The printing plate of claim 6, characterized in that the tin compound is dioctyltin bis(isooctylmercaptoacetate).

8. The printing plate of claim 6 or 7, characterized in that the catalyst is employed in an amount of 50 to 300 ppm based on the total weight of the components used to prepare the urethane polymer.

9. The printing plate of any of claims 1 to 5, characterized in that the catalyst is an aliphatic amine compound,

10. The printing plate of claim 9, characterized in that the catalyst is employed in an amount of 0.1% to 3% by weight, based on the total charge of the components used to prepare the urethane polymer.

11. The printing plate of any of the preceding claims, characterized in that the ratio of hydroxyl to isocyanate equivalents in step (1) is 1:1.1 to 1:2.0.

12. The printing plate of claim 11, characterized in that the ratio of hydroxyl to isocyanate equivalents in step (1) is 1:1.4.

13. The printing plate of any of claims 1 to 12, characterized in that said process further comprises (3) blending the urethane polymer with a polymerizable monomer, a photo-initiator and a stabilizer to produce a composition that is sensitive to actinic radiation.

14. A process for producing a printing plate according to any of claims 1 to 13, which comprises exposing the urethane polymer or a composition comprising the urethane polymer to ultraviolet radiation through a negative, washing away the unexposed portion with an aqueous alkaline detergent solution, and exposing the plate to ultraviolet radiation in air.

## Patentansprüche

1. Druckplatte, hergestellt aus einem Urethan-Polymer, dadurch gekennzeichnet, daß das Urethan-Polymer freie Carboxylgruppen und endständige Methacrylat-Gruppen aufweist und erhältlich ist nach einem Verfahren, das umfaßt (1) die Umsetzung einer Mischung von mindestens zwei aliphatischen Diolen und einer aliphatischen Dihydroxymono- oder -dicarbonsäure mit einem Überschuß eines aliphatischen, cyclo-aliphatischen oder aromatischen Diisocyanats in Gegenwart eines Katalysators unter Bildung eines Urethan-Polymers mit endständigem Isocyanat, das freie Carboxylgruppen an dem Polymer-Grundgerüst aufweist, und (2) die Umsetzung der endständigen Isocyanat-Gruppen des Produkts der Stufe (1) mit einem aliphatischen Monohydroxymethacrylat.

2. Druckplatte nach Anspruch 1, dadurch gekennzeichnet, daß die aliphatischen Diole eine Mischung von Polypropylenglycol und einem Block-Copolymer von Polypropylenoxid und Ethylenoxid darstellen.

3. Druckplatte nach Anspruch 1 oder 2, dadurch gekennzeichnet, daß es sich bei der Dihydroxymonocarbonsäure um Bis-hydroxymethylpropionsäure handelt.

4. Druckplatte nach Anspruch 1, 2 oder 3, dadurch gekennzeichnet, daß es sich bei dem Diisocyanat um Toluoldiisocyanat handelt.

5. Druckplatte nach einem der vorhergehenden Ansprüche, dadurch gekennzeichnet, daß es sich bei dem Monohydroxymethacrylat um 2-Hydroxypropylmethacrylat handelt.

6. Druckplatte nach einem der vorhergehenden Ansprüche, dadurch gekennzeichnet, daß es sich bei dem Katalysator um eine organische Zinn-Verbindung handelt.

7. Druckplatte nach Anspruch 6, dadurch gekennzeichnet, daß es sich bei der Zinn-Verbindung um Dioctylzinn-bis(isooctylmercaptoacetat) handelt.

8. Druckplatte nach Anspruch 6 oder 7, dadurch gekennzeichnet, daß der Katalysator in einer Menge von 50 bis 300 ppm, bezogen auf das Gesamtgewicht der zur Herstellung des Urethan-Polymers verwendeten Komponenten, eingesetzt wird.

9. Druckplatte nach einem der Ansprüche 1 bis 5, dadurch gekennzeichnet, daß es sich bei dem Katalysator um eine aliphatische Amin-Verbindung handelt.

10. Druckplatte nach Anspruch 9, dadurch gekennzeichnet, daß der Katalysator in einer Menge von 0,1 bis 3 Gew.-%, bezogen auf die Gesamt-Charge der zur Herstellung des Urethan-Polymers verwendeten Komponenten, eingesetzt wird.

11. Druckplatte nach einem der vorhergehenden Ansprüche, dadurch gekennzeichnet, daß das Äquivalent-Verhältnis Hydroxyl : Isocyanat in der Stufe (1) 1:1,1 bis 1:2,0 beträgt.

12. Druckplatte nach Anspruch 11, dadurch gekennzeichnet, daß das Äquivalent-Verhältnis Hydroxyl : Isocyanat in der Stufe (1) 1:1,4 beträgt.

13. Druckplatte nach einem der Ansprüche 1 bis 12, dadurch gekennzeichnet, daß das Verfahren außerdem umfaßt (3) das Mischen des Urethan-Polymers mit einem polymerisierbaren Monomer, einem Photoinitiator und einem Stabilisator zur Herstellung einer Zusammensetzung, die für aktinische Strahlung empfindlich ist.

14. Verfahren zur Herstellung einer Druckplatte nach einem der Ansprüche 1 bis 13, das umfaßt das Einwirkenlassen von ultravioletter Strahlung durch ein Negativ hindurch auf das Urethan-Polymer oder eine das Urethan-Polymer enthaltende Zusammensetzung, das Abwaschen des unbelichteten Abschnitts mit einer wäßrigen alkalischen Detergens-Lösung und das Einwirkenlassen von ultravioletter Strahlung auf die Platte an der Luft.

**Revendications**

1. Plaque d'impression fabriquée à partir d'un polymère d'uréthane, caractérisée en ce que le polymère d'uréthane possède des groupes carboxyle libres et des groupes méthacrylate terminaux et est susceptible d'être obtenu par un procédé qui comprend (1) la réaction d'un mélange d'au moins deux diols aliphatiques et d'un acide mono- ou di-carboxylique dihydroxylé aliphatique avec un excès d'un diisocyanate aliphatique, cycloaliphatique ou aromatique, en présence d'un catalyseur, pour produire un polymère d'uréthane à terminaison isocyanate comportant des groupes carboxyle libres sur la chaîne principale du polymère et (2) la réaction des groupes isocyanate terminaux du produit de l'étape (1) avec un méthacrylate monohydroxylé aliphatique.

2. Plaque d'impression selon la revendication 1, caractérisée en ce que les diols aliphatiques sont un mélange de polypropylèneglycol et d'un copolymère séquencé de poly(oxyde de propylène) et d'oxyde d'éthylène.

3. Plaque d'impression selon la revendication 1 ou 2, caractérisée en ce que l'acide monocarboxylique dihydroxylé est l'acide bis-hydroxyméthylpropionique.

4. Plaque d'impression selon la revendication 1, 2 ou 3, caractérisée en ce que le diisocyanate est le toluène diisocyanate.

**5.** Plaque d'impression selon l'une quelconque des revendications précédentes, caractérisée en ce que le méthacrylate monohydroxylé est le méthacrylate de 2-hydroxypropyle.

**6.** Plaque d'impression selon l'une quelconque des revendications précédentes, caractérisée en ce que le catalyseur est un composé d'étain organique.

**7.** Plaque d'impression selon la revendication 6, caractérisée en ce que le composé d'étain est le bis(isooctylmercaptoacétate) de dioctylétain.

**8.** Plaque d'impression selon la revendication 6 ou 7, caractérisée en ce que le catalyseur est employé à raison de 50 à 300 ppm, par rapport au poids total des constituants utilisés pour préparer le polymère d'uréthane.

**9.** Plaque d'impression selon l'une quelconque des revendications 1 à 5, caractérisée en ce que le catalyseur est un composé amine aliphatique.

**10.** Plaque d'impression selon la revendication 9, caractérisée en ce que le catalyseur est employé à raison de 0,1% à 3% en poids, par rapport à la charge totale des constituants utilisés pour préparer le polymère d'uréthane.

**11.** Plaque d'impression selon l'une quelconque des revendications précédentes, caractérisée en ce que le rapport des équivalents hydroxyle aux équivalents isocyanate dans l'étape (1) est de 1 : 1,1 à 1 : 2,0.

**12.** Plaque d'impression selon la revendication 11, caractérisée en ce que le rapport des équivalents hydroxyle aux équivalents isocyanate dans l'étape (1) est de 1 : 1,4.

**13.** Plaque d'impression selon l'une quelconque des revendications 1 à 12, caractérisée en ce que ledit procédé comprend en outre (3) le mélange du polymère d'uréthane avec un monomère polymérisable, un photo-initiateur et un stabilisant, pour produire une composition sensible au rayonnement actinique.

**14.** Procédé de production d'une plaque d'impression selon l'une quelconque des revendications 1 à 13, qui comprend l'exposition à un rayonnement ultraviolet, à travers un négatif, du polymère d'uréthane ou d'une composition comprenant le polymère d'uréthane, l'élimination de la partie non exposée par lavage avec une solution aqueuse détergente alcaline et l'exposition de la plaque à un rayonnement ultraviolet dans l'air.